# EUROPÄISCHE PATENTANMELDUNG

(11) **EP 1 289 012 A1**
(43) Veröffentlichungstag der Anmeldung: **05.03.2003**
(21) Anmeldenummer: 01120888.1
(22) Anmeldetag: 30.08.2001
(51) Int. Cl.: H01L 23/373, H01L 23/473

(54) **Integrierter Schaltkreis mit Kapillaren zur Entfernung von Wärme**

(71) Anmelder: SIEMENS AKTIENGESELLSCHAFT, 80333 München (DE)
(72) Erfinder: Renn, Harald, 90408 Nürnberg (DE)

(57) **Zusammenfassung**

Integrierter Schaltkreis (2) mit einer Wärmequelle (11), der in einem Substrat (1) realisiert ist, das zumindest eine ein Medium (3) enthaltende Kapillare (4) aufweist, deren Querschnitt sich im Bereich der Wärmequelle (11) verringert und sich im Bereich einer Wärmeabgabestelle (8) erhöht, wobei zwischen Wärmequelle (11) und Wärmeabgabestelle (8) ein Mittel (9) zum Transport des Mediums (3) vorgesehen ist, so dass bei bewegtem Medium (3) mittels der sich ergebenden Konvektionsströmung eine partielle Entwärmung des Bereichs um die Wärmequelle (11) möglich wird.

## Beschreibung

Die Erfindung betrifft einen integrierten Schaltkreis, der in einem Substrat realisiert ist.

Integrierte Schaltkreise sind allgemein bekannt. Durch den Stromfluss erzeugen integrierte Schaltkreise Wärme. Die Temperatur eines integrierten Schaltkreises ist jedoch einer der Parameter, die sich auf das Schaltverhalten des Schaltkreises auswirken. Daher ist es wünschenswert, dass der integrierte Schaltkreis näherungsweise stets bei gleicher Temperatur betrieben wird. Wo dies nicht erreicht werden kann, wird zumindest angestrebt, dass eine vorgegebene für den Schaltkreis spezifische Maximaltemperatur nicht überschritten wird.

Ein Betreiben des Schaltkreises außerhalb einer spezifischen Solltemperatur oder außerhalb eines spezifischen Solltemperaturbereichs hat zur Folge, dass die Schaltreaktion nicht in der gewünschten Art determiniert ist. Außerdem verringert ein fortgesetztes Betreiben des Schaltkreises oberhalb seiner Maximaltemperatur dessen Lebensdauer.

Bekannte Lösungen zur Entwärmung integrierter Schaltkreise setzen auf eine passive Abführung der Wärme durch das Substrat. Der Nachteil dieser Lösung ist, dass auch benachbarte Transistoren stark erwärmt werden, da die Wärmekonvektionsströmung sich gleichmäßig über den gesamten integrierten Schaltkreis, im folgenden auch kurz als Chip bezeichnet, verteilt. Dabei ist die maximal Wärmeabfuhrmenge des Substrats, durch die Wärmeleitzahl des Substratmaterials, z.B. Silizium, bestimmt.

Die Aufgabe der Erfindung besteht darin, einen integrierten Schaltkreis mit partieller Reduzierung der Verlustwärme anzugeben. Der Vorteil der Erfindung besteht darin, dass damit eine Entwärmung des Chips genau an den Orten möglich ist, an denen Wärme erzeugt wird.

Gemäß der Erfindung ist dazu ein integrierter Schaltkreis mit einer Wärmequelle vorgesehen, der in einem Substrat realisiert ist, das zumindest eine ein Medium enthaltende Kapillare mit einem Abschnitt mit geringem Querschnitt und einem Abschnitt mit größerem Querschnitt aufweist, wobei ein erster Übergang zwischen den beiden Abschnitten im Bereich der Wärmequelle und ein zweiter Übergang zwischen den beiden Abschnitten im Bereich einer Wärmeabgabestelle und zwischen erstem und zweitem Übergang - im Bereich des Abschnitts mit größerem Querschnitt - ein Mittel zum Transport des Mediums vorgesehen ist.

Das bewegte Medium erzeugt eine Konvektionsströmung die Wärme im Bereich der Wärmequelle aufnimmt und die aufgenommene Wärme im Bereich der Wärmeabgabestelle wieder abgibt. Die Wärmeaufnahme erfolgt aufgrund einer Expansion des Mediums beim Übergang vom geringen zum größeren Querschnitt der Kapillare. Die Wärmeabgabe erfolgt entsprechend aufgrund einer Kompression des Mediums bei Übergang vom größeren zum geringeren Querschnitt der Kapillare.

Vorteilhafte Ausgestaltungen der Erfindung sind Gegenstand der abhängigen Ansprüche.

Die Dimension des Mittels zum Transport des Mediums legt maßgeblich den Querschnitt des Abschnitts mit größerem Querschnitt und damit mittelbar auch den des Abschnitts mit geringem Querschnitt fest. Ein erstes Mittel, das bei geringem Platzbedarf zum Transport des Mediums geeignet ist, ist ein so genannter Nanomotor. Ein alternatives Mittel ist ein gepulster Laser.

Wenn Geschwindigkeit des Transports des Mediums, die Strömungsgeschwindigkeit der Konvektionsströmung, regelbar ist, ist es möglich spezifisch auf Phasen höhere und geringer Wärmeabgabe durch die Wärmequelle zu reagieren, in dem die Strömungsgeschwindigkeit in Abhängigkeit von der Temperatur der Wärmequelle geregelt wird.

Wenn im Bereich der Wärmeabgabestelle an der Außenseite des Substrats ein Kühlkörper vorgesehen ist, ist es möglich, nicht nur lokal die Wärmequelle, sondern auch die Wärmeabgabestelle zu entwärmen. Damit wird vermieden, dass die Temperatur des Substrats insgesamt ansteigt, was schließlich auch zu einer geringeren Entwärmung der Wärmequelle führen würde.

Wenn im Bereich der Wärmeabgabestelle an der Außenseite des Substrats ein Wärmeleiter vorgesehen ist, ist möglich, die abgeführte Wärme einer Wärmequelle eines z.B. in einem Gehäuse platzierten integrierten Schaltkreises an eine Oberfläche oder eine Außenseite des Gehäuses zu leiten und damit auch eine Entwärmung eines in dem Gehäuse vorgesehenen Gesamtgerätes zu bewirken.

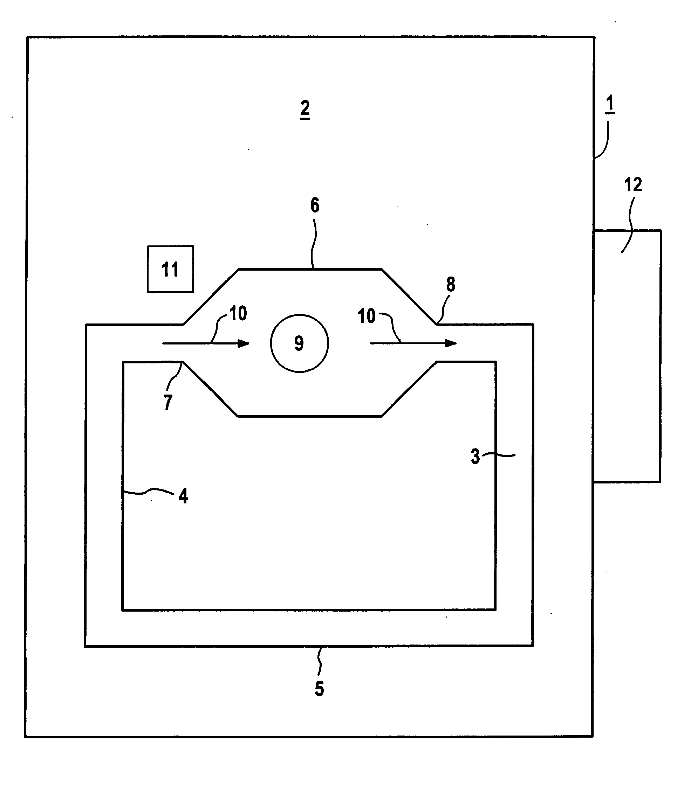

Nachfolgend ist ein Ausführungsbeispiel der Erfindung anhand der Zeichnungen beschrieben. Darin zeigt
- FIG 1: einen integrierten Schaltkreis in einem Substrat.

FIG 1 zeigt das Substrat 1 eines integrierten Schaltkreises 2. Das Substrat 1 weist eine mit einem Medium 3 gefüllte Kapillare 4 auf. Die Kapillare 4 ist geschlossen und ist an keiner Stelle zur Außenfläche des Substrats 1 hin geöffnet. Dies aus dem Grunde, weil der Querschnitt der Kapillare 4 relativ gering ist, so dass ein Eindringen von notwendig verschmutzter Umgebungsluft diese verstopfen könnte.

Die Kapillare 4 weist einen Abschnitt 5 mit geringem Querschnitt und einen Abschnitt 6 mit größerem Querschnitt auf. Damit ergibt sich eine erste und zweite Übergangsstelle 7, 8 beim Übergang vom dem geringen Querschnitt auf den größeren Querschnitt.

Zwischen den beiden Übergangsstellen 7, 8 im Abschnitt 6 mit größerem Querschnitt, vorzugsweise etwa mittig zwischen den beiden Übergangsstellen 7, 8 ist ein Mittel 9 zum Transport des Mediums 3 vorgesehen. Das Mittel 9 ist z.B. ein so genannter Nanomotor 9. Der Nanomotor 9 bewegt das Medium 3 und erzeugt damit eine Konvektionsströmung 10 (durch einen Pfeil angedeutet) in der Kapillare 4. Eine alternative Möglichkeit zur Bewegung des Mediums 3 besteht in der Anwendung einer so genannten Laserpulsung.

Als erste Übergangsstelle 7 wird im folgenden der Übergang vom Abschnitt 5 mit geringem Querschnitt zum Abschnitt 6 mit größerem Querschnitt entlang der Konvektionsströmung 10 bezeichnet. Entsprechend wird als zweite Übergangsstelle 8 im folgenden der Übergang vom Abschnitt 6 mit größerem Querschnitt zum Abschnitt 5 mit geringem Querschnitt entlang der Konvektionsströmung 10 bezeichnet.

Die Position der ersten Übergangsstelle 7 wird innerhalb des Substrates 1 so gewählt, dass sie sich im Bereich einer Wärmequelle 11, z.B. einem Transistor 11, befindet. Die Position der zweiten Übergangsstelle 8 wird entsprechend innerhalb des Substrates 1 so gewählt, dass sie sich in einem Bereich 8 befindet, der zur Wärmeabgabe geeignet ist. Dieser Bereich 8, der im wesentlichen mit der zweiten Übergangsstelle 8 zusammenfällt, wird im folgenden als Wärmeabgabestelle 8 bezeichnet. Die Wärmeabgabestelle 8 befindet sich vorzugsweise im Bereich der Oberfläche des Substrats 1 oder in einem sonst zur Entwärmung geeigneten Bereichs des Substrats 1. Ein zur Entwärmung geeigneter Bereich des Substrats 1 kann auch ein Bereich sein, in dem keine Verlustleistung durch den integrierten Schaltkreis 2 anfällt und damit keine Wärme erzeugt wird.

Der Verlauf der Kapillare 4 innerhalb des Substrats 1 ist im wesentlichen durch die Position von Wärmequelle 11 und Wärmeabgabestelle 8 festgelegt.

Das durch den Nanomotor 9 bewegte Medium 3 dehnt sich im Bereich der Wärmequelle 11 aus. Durch die Expansion des Mediums 3 aufgrund des Übergangs zum größeren Querschnitt an der ersten Übergangsstelle 7 wird eine lokale Verringerung der Umgebungstemperatur erreicht.

An der zweiten Übergangsstelle 8 wird das Medium 3 komprimiert. Die aufgenommene Wärmemenge wird hier wieder abgegeben. Damit ist die lokale Entwärmung des Substrats 1 im Bereich der Wärmequelle 11 erreicht. Die lokal aufgenommene Wärme wird durch die Konvektionsströmung 10 zu einem zur Entwärmung geeigneten Bereich 8 des Substrats 1 transportiert.

Der Kühlkreislauf ist in sich geschlossen, d.h. er hat keine Verbindung zur Luft außerhalb des Substrats 1, da durch die Größe der Kapillare 4 ein offenes System zum Verschmutzen und somit zum totalen Kühlungsausfall führen würde. Das Medium 3 ist vorzugsweise ein Gas mit geeigneter Molekülgröße, so dass eine ungehinderte Konvektionsströmung durch die Kapillare 4 möglich ist.

Im Bereich der Wärmeabgabestelle 8 kann besonders vorteilhaft auf der Außenfläche des Substrats 1 ein passiver oder aktiver Kühlkörper 12 angebracht sein. Anstelle des Kühlkörpers 12 kann - wenn sich der integrierte Schaltkreis 2 z.B. in einem Gehäuse (nicht dargestellt) befindet und damit aufgrund des begrenzten Luftvolumens innerhalb des Gehäuses selbst nur begrenzt entwärmt werden kann - auch ein Wärmeleiter 12 vorgesehen sein, durch den die bereits innerhalb des Substrats 1 transportierte Wärme nochmals und diesmal zur Außenseite des Gehäuses transportiert wird.

Über eine der Außenflächen des Substrats 1 kann eine größere Verbindungsfläche zu einem Gehäuse aufgebaut werden. Um eine gute Wärmeabführung zu erreichen, sind für den Wärmeleiter 12 Materialien mit einem guten Wärmekoeffizienten zu verwenden (z. B. Kupfer, Silber, Gold). Die Materialien können bei der Herstellung des integrierten Schaltkreises aufgedampft werden. Dies wird zur Zeit bereits beim Aufbringen von Leiterbahnen praktiziert.

Zusammenfassend lässt sich die Erfindung damit wie folgt beschreiben:

Es wird eine Möglichkeit zur partiellen Reduzierung der Verlustwärme innerhalb eines integrierten Schaltkreises 2 durch die Verwendung einer oder mehrerer gekapselter Kapillaren 4 angegeben.

Dazu ist ein integrierter Schaltkreis 2 mit einer Wärmequelle 11 vorgesehen, der in einem Substrat 1 realisiert ist, das zumindest eine ein Medium 3 enthaltende Kapillare 4 aufweist, deren Querschnitt sich im Bereich der Wärmequelle 11 verringert und sich im Bereich einer Wärmeabgabestelle 8 erhöht, wobei zwischen Wärmequelle 11 und Wärmeabgabestelle 8 ein Mittel 9 zum Transport des Mediums 3 vorgesehen ist.

## Patentansprüche

1. Integrierter Schaltkreis (2) mit einer Wärmequelle (11), der in einem Substrat (1) realisiert ist, das zumindest eine ein Medium (3) enthaltende Kapillare (4) mit einem Abschnitt (5) mit geringem Querschnitt und einem Abschnitt (6) mit größerem Querschnitt aufweist, wobei ein erster Übergang (7) zwischen den beiden Abschnitten (5, 6) im Bereich der Wärmequelle (11) und ein zweiter Übergang (8) zwischen den beiden Abschnitten (5, 6) im Bereich einer Wärmeabgabestelle (8) und zwischen erstem und zweitem Übergang (7, 8) ein Mittel (9) zum Transport des Mediums (3) vorgesehen ist.

2. Integrierter Schaltkreis nach Anspruch 1, wobei das Mittel (9) ein Nanomotor (9) ist.

3. Integrierter Schaltkreis nach Anspruch 1, wobei das Mittel (9) ein gepulster Laser ist.

4. Integrierter Schaltkreis nach einem der obigen Ansprüche, wobei eine Geschwindigkeit des Transports des Mediums (3) regelbar ist.

5. Integrierter Schaltkreis nach einem der obigen Ansprüche, wobei im Bereich der Wärmeabgabestelle (8) an der Außenseite des Substrats (1) ein Kühlkörper (12) vorgesehen ist.

6. Integrierter Schaltkreis nach einem der obigen Ansprüche, wobei im Bereich der Wärmeabgabestelle (8) an der Außenseite des Substrats (1) ein Wärmeleiter (12) vorgesehen ist.
